# FASCICULE DE BREVET EUROPEEN

(11) **EP 2 659 307 B1**
(45) Date de publication et mention de la délivrance du brevet: **21.02.2018**
(21) Numéro de dépôt: 11813881.7
(22) Date de dépôt: 26.12.2011
(51) Int. Cl.: C23C 18/16

(54) **PROCÉDÉ DE FABRICATION D'OBJETS DE GRANDE PRÉCISION PAR LITHOGRAPHIE HAUTE RÉSOLUTION ET PAR DÉPÔT PAR VOIE SÈCHE ET OBJETS AINSI OBTENUS**
VERFAHREN ZUR HERSTELLUNG VON HOCHPRÄZISIONSOBJEKTEN MITTELS HOCHAUFLÖSENDER LITHOGRAPHIE UND TROCKENABSCHEIDUNG SOWIE DABEI ERHALTENE OBJEKTE
PROCESS FOR FABRICATING HIGH-PRECISION OBJECTS BY HIGH-RESOLUTION LITHOGRAPHY AND DRY DEPOSITION AND OBJECTS THUS OBTAINED

(30) Priorité: 29.12.2010 FR 1005157
(43) Date de publication de la demande: 06.11.2013
(73) Titulaire: ONERA (Office National d'Etudes et de Recherches Aérospatiales), 91120 Palaiseau (FR); Centre National de la Recherche Scientifique (C.N.R.S.), 75794 Paris Cedex 16 (FR)
(72) Inventeur: LANDAIS, Stéphane, F-92370 Chaville (FR); BOUAMRANE, Fayçal, F-91190 Gif sur Yvette (FR); BOUVET, Thomas, F-75015 Paris (FR); DESSORNES, Olivier, F-91140 Villebon s/Yvette (FR); JOSSO, Pierre, F-92130 Issy-les-Moulineaux (FR); MEGTERT, Stéphan, F-91140 Villebon s/Yvette (FR); VALLE, Roger, F-92140 Clamart (FR)
(74) Mandataire: de Kernier, Gabriel
(86) Numéro de dépôt international: PCT/FR2011/000679
(87) Numéro de publication internationale: WO 2012/089934

(56) Documents cités:
- EP-A1- 1 835 050
- EP-A1- 2 263 846
- WO-A1-2009/158631
- GB-A- 2 429 841
- US-A1- 2004 144 653
- US-A1- 2007 259 293
- US-A1- 2008 093 424
- US-B1- 6 506 675
- US-B1- 6 518 168

## Description

L'invention concerne un procédé de fabrication d'objets de grande précision par lithographie haute résolution ainsi que les objets obtenus par la mise en oeuvre de ce procédé.

Elle s'intéresse tout particulièrement à la fabrication d'objets de grande précision en matériaux non déposables par galvanoplastie, et tout spécialement d'objets de faible dimension, c'est-à-dire de dimension millimétrique. Il peut s'agir, par exemple, d'objets ou de composants micromécaniques ou de Systèmes ElectroMécaniques (ou MEMS, abréviation de Micro-Electro-Mechanical Systems) utilisés dans le domaine de l'aéronautique, de l'horlogerie, etc.

Il est bien connu de l'homme de l'art qu'il n'est pas possible d'atteindre un tel résultat grâce à la seule technique dite "LIGA", acronyme de l'expression allemande "Lithographie, Galvanoformung, Abformung", qui signifie "Lithographie, Galvanoplastie, Moulage".

Cette technique consiste à revêtir un substrat, conducteur ou non conducteur de l'électricité, d'une résine polymérisée (résine positive) ou d'une résine photopolymérisable (résine négative). Cette résine est illuminée à travers un masque qui comporte des régions opaques (ou transparentes) par un rayonnement électromagnétique adapté de courte longueur d'onde, c'est-à-dire allant de l'ultra-violet (LIGA-UV) aux rayons X (LIGA-X). Par cette technique, on réalise ainsi un "pochoir" qui définit les structures à imprimer dans l'épaisseur de la résine. La conséquence de l'interaction polymère/onde électromagnétique est soit de détruire la polymérisation dudit polymère (résine positive), soit d'engendrer la polymérisation et/ou la réticulation de la résine (résine négative).

Les chaînes du polymère ayant été sectionnées (résine positive) ou au contraire aucune réaction de polymérisation-réticulation n'ayant été engendrée (résine négative), ce polymère peut être facilement éliminé.

Les jours ou lumières ainsi créés dans la résine peuvent être mis à profit, soit pour y faire croître un dépôt par électrolyse d'une solution (procédé LIGA proprement dit), soit pour dissoudre tout ou partie du substrat sur lequel la résine était déposée (cas de la dissolution du cuivre par du perchlorure de fer pour la fabrication des circuits imprimés, par exemple). Ces techniques ont été abondamment enseignées dans la littérature.

Un procédé LIGA typique, connu de l'état de l'art, comprend les étapes suivantes :
- choisir un substrat conducteur de l'électricité ;
- déposer sur le substrat une couche de résine photosensible d'une épaisseur variant de 10µm à 2mm ;
- polymériser ladite résine, si nécessaire ;
- disposer un masque au-dessus de la surface de la résine ;
- irradier la résine au moyen d'une ligne de lumière (rayons X) d'un synchrotron (LIGA-X) ou d'une lampe à rayonnement ultra-violet (LIGA-UV) ;
- développer, c'est-à-dire éliminer la résine dépolymérisée (résine positive) ou non polymérisée-réticulée (résine négative) ;
- électroformer dans la cavité créée un métal ou un alliage (fer, nickel, cobalt, cuivre, zinc, ou des alliages tels que nickel-cobalt, nickel-palladium ou des co-dépôts tels que zinc-nickel, cobalt-étain, ou encore des dépôts composites tels que NiCo + CrAlYTa, cette liste étant non limitative) ;
- éliminer la résine photosensible ; et
- séparer du substrat conducteur de l'électricité, les composants micromécaniques ainsi fabriqués.

Une telle technique a l'avantage de pouvoir réaliser des composants d'une très grande précision dans le plan du dépôt. En revanche, la précision dans la direction perpendiculaire au plan du dépôt (épaisseur du dépôt), est, quant à elle, liée à la maîtrise du procédé de dépôt. Pour obtenir une précision meilleure que micrométrique dans cette direction perpendiculaire au plan du dépôt, il existe, bien sûr, la possibilité de créer des formes imbriquées du même matériau ou d'un matériau différent. Il suffit alors de répéter la procédure sur le premier niveau créé, avec un second masque par exemple, soit en conservant le même dépôt, soit en le changeant.

L'inconvénient d'un tel procédé est toutefois de nécessiter des matériaux conducteurs de l'électricité, sauf, peut-être, dans le cas où un matériau, tel qu'un oxyde, serait enchâssé au sein de la structure (dépôt composite ou enchâssement d'une pierre tel qu'il est pratiqué par les galvanoplastes versés dans la bijouterie).

Ainsi, quelle que soit la technique utilisée, il existe une limitation aux matériaux qui formeront l'objet final. Cette limitation est liée, soit dans le cadre d'un dépôt électrolytique, aux lois de l'électrochimie pour déposer le matériau final (il n'est pas possible de réduire des éléments dont le potentiel normal d'oxydoréduction (RedOx) est inférieur au domaine de stabilité thermodynamique de leur solvant, en général de l'eau), soit, dans le cadre d'un usinage de précision par voie chimique de l'objet final, aux lois de la chimie (il faut que le matériau de cet objet soit soluble dans la solution d'attaque).

Enfin, cette technique ne peut pas non plus permettre de fabriquer des objets micromécaniques d'assez grandes dimensions, tels que des paliers à gaz de 4mm de long et de faible diamètre.

L'invention a notamment pour but de surmonter les inconvénients précités, le problème à résoudre étant de fabriquer un objet micromécanique dans un ou des matériaux, non déposables par galvanoplastie, susceptibles de pouvoir supporter de très fortes contraintes environnementales (corrosion, etc.) et thermo-mécaniques, donc de dimension millimétrique ou supérieure, notamment en ce qui concerne son épaisseur, et pouvant avoir des formes qui ne sont pas de révolution, tout en étant de précision micrométrique, y compris en ce qui concerne la pente des parois réalisées dans l'épaisseur de l'objet, l'erreur de pente visée devant être inférieure à 1 micromètre par millimètre d'épaisseur.

L'invention propose à cet effet un procédé de fabrication d'un objet de grande précision formé d'au moins un matériau inorganique, comprenant les étapes suivantes :
- utiliser un procédé de photolithographie à haute résolution mettant en oeuvre, suivant une direction choisie Z, un rayonnement de longueur d'onde adaptée au degré de précision désiré, pour former un moule négatif non déformable à l'échelle micrométrique au cours des étapes du procédé, dans un matériau résistant à une étape de formage de l'objet par dépôt par voie sèche et pouvant soit être éliminé sans altération de l'objet qui aura été fabriqué, soit être séparé dudit objet ;
- choisir, indépendamment du potentiel normal d'oxydoréduction de ses éléments constitutifs, au moins un matériau inorganique parmi l'ensemble des matériaux pouvant être déposés par voie sèche et susceptibles de permettre à l'objet à fabriquer de satisfaire à ses contraintes thermomécaniques et environnementales ; et
- réaliser, au moyen du moule négatif non déformable, le formage de l'objet à fabriquer par dépôt par voie sèche dudit au moins un matériau inorganique, ce qui permet de fabriquer un objet comportant au moins une partie en forme de cylindre droit (qui n'est pas nécessairement de révolution) de génératrice parallèle à la direction choisie Z, d'épaisseur d'ordre millimétrique (l'épaisseur de l'objet ne correspondant pas nécessairement à l'épaisseur du dépôt) selon la direction Z, la précision des différentes parties de l'objet étant meilleure que micrométrique, notamment en ce qui concerne le parallélisme entre ladite direction Z et les parois de ladite partie générées par dépôt par voie sèche, l'erreur de pente étant inférieure à 1 micromètre par millimètre d'épaisseur.

Ainsi, le procédé de l'invention réside pour l'essentiel dans la combinaison de deux techniques en soi connues séparément, à savoir un procédé de photolithographie à haute résolution par rayonnement (par exemple X ou UV) et un dépôt par voie sèche.

La première technique permet de réaliser directement ou indirectement un moule négatif non déformable, c'est-à-dire une empreinte de l'objet à fabriquer, dans un matériau résistant tel que défini précédemment.

La deuxième technique permet de réaliser un dépôt par voie sèche du matériau inorganique dans ou sur le moule négatif pour constituer l'objet à fabriquer.

La combinaison de la photolithographie à haute résolution par rayonnement X, dans une direction choisie Z, c'est-à-dire dans la direction du faisceau de photolithographie, et du dépôt par voie sèche permet de réaliser des pièces micromécaniques comportant au moins une partie en forme de cylindre droit dont la génératrice est parallèle à ladite direction choisie Z. La pièce est obtenue avec une épaisseur d'ordre millimétrique selon la direction Z et une précision micrométrique notamment du parallélisme entre la direction Z et les parois générées par ledit dépôt par voie sèche, et cela dans un ou plusieurs matériaux non déposables par galvanoplastie.

Le ou les matériaux précités sont des matériaux inorganiques constitués d'éléments déposables concomitamment et choisis indépendamment du potentiel normal d'oxydoréduction de leurs éléments constitutifs, ce qui élargit l'éventail des matériaux utilisables à des matériaux non déposables par galvanoplastie. En effet, il est bien connu de l'homme de l'art que l'électroformage d'objets est limité dans le choix de l'élément ou des éléments à déposer par son/ses potentiels d'oxydoréduction associé(s) au domaine de stabilité thermodynamique du solvant choisi pour la mise en solution des sels.

La technique LIGA est bien connue et a fait l'objet de nombreuses publications dans la littérature. On peut se référer notamment aux deux publications suivantes : « Microgrippers fabricated by the LIGA technique" par S. Ballandras, S. Basrour, L. Robert, S. Megtert, P. Blind, M. Rouillay, P. Bernède, W. Daniau in Sensors and Actuators A: Physical, Volume 58, Issue 3, 30 March 1997, pages 265-272 et "Microfabrication : LIGA-X and applications" par R. K. Kupka, F. Bouamrane, C. Cremers, S. Megtert in Applied Surface Science, Volume 164 issues 1-4, 1 September 2000, pages 97-110*.*

La deuxième technique met en oeuvre un dépôt par voie sèche du ou des matériaux inorganiques devant constituer l'objet à fabriquer.

Par l'expression « dépôt par voie sèche », on entend désigner ici tout procédé de dépôt par voie sèche, pourvu que l'empreinte obtenue par la technique de lithographie haute résolution résiste aux conditions physico-chimiques, notamment à l'atmosphère et à la température du dépôt par voie sèche. Il est donc nécessaire que le matériau constitutif du moule négatif soit capable de résister à l'étape de formage par dépôt par voie sèche et qu'il puisse ensuite soit être éliminé sans altération de l'objet qui aura été fabriqué, soit être séparé dudit objet.

Ce dépôt par voie sèche est avantageusement choisi parmi les suivants :
- un dépôt physique par pulvérisation cathodique triode (PCT),
- un dépôt chimique en phase vapeur ou CVD (abréviation de Chemical Vapor Deposition), assisté ou non par plasma,
- un dépôt par frittage à plasma d'étincelles ou SPS (abréviation de Spark Plasma Sintering),
- un dépôt physique en phase vapeur ou PVD (abréviation de Physical Vapor Deposition), et
- un dépôt physique par évaporation, par exemple un dépôt physique en phase vapeur par faisceau d'électrons ou EB-PVD (abréviation de Electron Beam Physical Vapor Deposition).

Parmi les différentes techniques de dépôt physique mentionnées précédemment, on préfère tout particulièrement le dépôt par pulvérisation cathodique triode (PCT), connu aussi sous le nom de "Triode Sputtering", terme anglo-saxon.

De plus amples informations sur ce dépôt par pulvérisation cathodique triode peuvent être trouvées dans le brevet US 4 111 783.

Cependant, il faut noter qu'il existe souvent une confusion entre la pulvérisation cathodique triode et la pulvérisation cathodique diode, plus connue sous son appellation anglo-saxonne : « Physical Vapor Deposition » (en abrégé PVD).

Cette dernière technique PVD, constituant un dépôt physique en phase vapeur, est également envisagée dans le cadre de l'invention, comme mentionné plus haut.

Dans le cadre des techniques LIGA, la technique PVD est essentiellement utilisée pour des buts différents :
- au cours de l'étape lithographique pour réaliser des masques opaques aux rayons X (LIGA-X), comme enseigné notamment par le brevet US 6 810 104 B2, et
- pour réaliser une couche d'accrochage métallique permettant d'effectuer un électroformage (LIGA-UV), comme enseigné par la demande de brevet EP 1 835 050 A1.

Les techniques de dépôt physique par voie sèche sont également connues. En particulier, la pulvérisation cathodique triode (PCT) permet d'obtenir des dépôts minces et épais (jusqu'à quelques dixièmes de millimètres), et ceci pour des applications très diverses.

On citera, par exemple, les études réalisées dans le domaine des composites à matrice titane qui ont permis d'élaborer, par dépôt PCT de titane ou d'aluminure de titane (TiAl) sur fibres, des matériaux possédant une excellente homogénéité structurale et sans altération de la fibre. Cette technique est, par exemple, décrite dans la publication "Continuous fibre reinforced titanium and aluminium composites : a comparison", A. Vassel in Materials Science and Engineering, Volume A263, 1999, pages 305-313 et dans "Intermetallic TiAl-based matrix composites : Investigation of the chemical and mechanical compatibility of a protective coating adapted to an alumina fibre", A. Brunet, R. Valle, A. Vassel in Acta Materialia, Volume 48, 2000, pages 4763-4774*.*

Comme indiqué précédemment, parmi les dépôts physiques par voie sèche, utilisables dans l'invention, on préfère particulièrement le dépôt par pulvérisation cathodique triode (PCT).

L'appareillage utilisé pour les dépôts PCT peut être décrit comme une enceinte à vide (avec un pompage cryogénique) contenant un gaz plasmagène (argon par exemple) régulé en débit et pression. Un filament de tungstène chauffé par effet Joule émet des électrons qui sont accélérés par une anode. Ces électrons interagissent avec les atomes d'argon pour donner des ions Ar⁺. Un champ magnétique créé par deux bobines disposées au dessus et en dessous de la cible permet d'allonger et de confiner les trajectoires électroniques au niveau de la surface de la cible afin d'accroître les chances d'ionisation des molécules de gaz neutre à cet endroit. Ceci a pour conséquence d'augmenter le bombardement de la cible métallique, constituée du matériau à déposer, et de provoquer ainsi un arrachement des atomes de ce matériau qui vont se déposer sur l'objet à revêtir.

L'avantage de cette technique est que le potentiel électrique de la cible n'a aucune influence sur le maintien de la décharge, ce qui permet l'utilisation éventuelle de faibles tensions. Ainsi, les risques de claquage sont réduits et le bombardement engendré étant à des énergies plus faibles, le refroidissement nécessaire de la cible est moindre. Cette indépendance de la cible par rapport au plasma fait que la cible peut avoir n'importe quelle forme, ce qui n'est pas le cas avec des procédés diode. Le substrat, lui aussi, peut être sous n'importe quelle forme. Du fait que le procédé est directif, l'homogénéité du dépôt dépend ensuite de son mouvement et des ombrages éventuels. De plus, dans le système triode, la décharge peut être entretenue à une pression plus faible que dans le montage diode à courant continu (DC diode, PVD traditionnel) de l'ordre de 10 ⁻¹ à 10 ⁻² Pa, ce qui est un avantage du point de vue de la contamination des couches par le gaz utilisé pour former le plasma. Enfin, la vitesse de dépôt est très élevée.

Il n'était pas possible jusqu'à présent de réaliser des objets, en particulier des objets micromécaniques dans des matériaux, non déposables par galvanoplastie, capables de supporter de très fortes contraintes thermomécaniques et environnementales (corrosion, etc.), de précision micrométrique, notamment en ce qui concerne le parallélisme entre les parois générées et la direction Z de photolithographie (erreur de pente inférieure à 1 micromètre par millimètre d'épaisseur) et a fortiori de dimension millimétrique ou supérieure et pouvant avoir des formes qui ne sont pas de révolution.

Plus précisément, l'invention, qui consiste essentiellement à combiner deux techniques mentionnées précédemment, à savoir d'une part, un procédé de photolithographie haute résolution, par exemple par rayonnement X ou UV, et d'autre part, un procédé de dépôt par voie sèche, comme par exemple la pulvérisation cathodique triode, permet d'obtenir un tel résultat.

Le dépôt physique par voie sèche, comme par exemple la pulvérisation cathodique triode, en remplacement de l'électroformage, apporte l'avantage d'élargir l'éventail des matériaux disponibles pour obtenir un dépôt : métaux purs, alliages multi-composant et superalliages par plasma neutre ou, par plasma réactif, oxydes, nitrures, carbures ... et, enfin, mélanges de tous ces matériaux avec les systèmes multi-cible.

D'autres procédés de dépôt sont envisageables, à condition que l'empreinte obtenue par la technique de lithographie haute résolution résiste aux conditions physico-chimiques de dépôt.

Comme déjà dit, le procédé de l'invention peut être mis en oeuvre selon deux variantes principales, correspondant respectivement à un procédé dit "direct" et un procédé dit "indirect".

Dans le procédé direct, le moule négatif est formé directement dans le matériau résistant. Ce dernier peut être, par exemple, une résine photosensible ou un métal.

Dans le procédé indirect, le moule négatif est formé indirectement dans le matériau résistant, l'étape du procédé de lithographie à haute résolution comprenant alors les sous-étapes suivantes :
- former un moule positif de l'objet à fabriquer dans un premier matériau,
- réaliser dans ou sur le moule positif un dépôt d'un second matériau résistant et qui est destiné à constituer le moule négatif.

Le procédé de fabrication d'un objet micromécanique de dimension millimétrique ou supérieure, de grande précision, formé d'au moins un matériau inorganique, comprend les étapes suivantes :
- utiliser un procédé de photolithographie à haute résolution mettant en oeuvre, suivant une direction choisie Z, un rayonnement de longueur d'onde adaptée, pour former, sur ou dans un substrat de matériau choisi, un moule négatif de précision micrométrique sur une hauteur millimétrique comportant au moins une partie en forme de cylindre droit de génératrice parallèle à la direction choisie Z, ledit moule négatif étant non déformable à l'échelle micrométrique au cours des étapes du procédé, dans un matériau résistant aux conditions physico-chimiques et de température d'une étape de formage de l'objet par dépôt par voie sèche et pouvant soit être éliminé sans altération de l'objet qui aura été fabriqué, soit être séparé dudit objet, ledit matériau résistant étant soit une résine photosensible, auquel cas le substrat est refroidi et fait partie intégrante dudit objet, soit un matériau déposé par galvanoplastie, auquel cas une étape préalable de formage d'un moule positif en résine photosensible de l'objet est réalisée;
- choisir, indépendamment du potentiel normal d'oxydoréduction de ses éléments constitutifs, au moins un matériau inorganique parmi l'ensemble des matériaux non déposables par galvanoplastie mais pouvant être déposés par voie sèche; et
- réaliser, au moyen du moule négatif non déformable, par dépôt par voie sèche dudit au moins un matériau inorganique, un formage d'objet micromécanique de dimension millimétrique ou supérieure.

Avantageusement, dans un deuxième mode de réalisation du procédé de l'invention, il comprend une étape préalable dans laquelle on choisit un substrat qui sera utilisé ensuite dans le procédé de lithographie haute résolution pour réaliser le moule négatif.

Le moule négatif pourra, selon les cas, être déposé sur le substrat (photolithographie) ou être creusé dans le substrat. De plus, le substrat pourra, selon les cas, être éliminé en partie ou en totalité, être séparé ou être conservé comme partie intégrante de l'objet final à fabriquer. La nature du substrat sera donc choisie à chaque fois en fonction du cas d'espèce considéré (par exemple, un substrat de nickel avec un dépôt de superalliage peut être dissous par une attaque chimique sélective, sans altération du dépôt).

Avantageusement, dans un troisième mode de réalisation du procédé de l'invention, selon le deuxième mode de réalisation, le moule négatif est formé directement dans le matériau résistant.

Avantageusement, dans un quatrième mode de réalisation du procédé de l'invention, selon le deuxième mode de réalisation, le matériau résistant est une résine photosensible déposée sur ledit substrat.

Avantageusement, dans un cinquième mode de réalisation du procédé de l'invention, selon le deuxième mode de réalisation, le matériau résistant est un métal déposé sur ledit substrat.

Avantageusement, dans un sixième mode de réalisation du procédé de l'invention, selon l'un des modes de réalisation précédents, le procédé de photolithographie à haute résolution est un procédé de photolithographie mettant en oeuvre un rayonnement X.

En effet, le procédé de photolithographie à haute résolution est avantageusement un procédé de photolithographie mettant en oeuvre un rayonnement X pour des dépôts d'épaisseur millimétrique, simples ou entrant dans l'élaboration d'objets multicouche.

Avantageusement, dans un septième mode de réalisation du procédé de l'invention, selon l'un des modes de réalisation précédents, le procédé de photolithographie à haute résolution est un procédé de photolithographie mettant en oeuvre un rayonnement UV.

En effet, dans le cas de dépôts d'épaisseur micrométrique, simples ou entrant dans l'élaboration d'objets multicouche d'épaisseur millimétrique, il est possible de mettre en oeuvre un rayonnement X mais aussi un rayonnement UV.

Dans le cas où une plus grande précision serait recherchée ou dans celui où l'épaisseur de l'objet selon la direction Z serait supérieure à plusieurs millimètres, un rayonnement de longueur d'onde plus courte, comme les rayons gamma par exemple, pourrait être utilisé.

Avantageusement, dans un huitième mode de réalisation du procédé de l'invention, selon l'un des modes de réalisation précédents, le procédé de l'invention comprend les étapes ultérieures suivantes :
- éliminer le moule négatif ou le séparer de l'objet à fabriquer ; et
- récupérer l'objet ainsi fabriqué.

Avantageusement, dans un neuvième mode de réalisation du procédé de l'invention, selon l'un des modes de réalisation précédents, l'étape du procédé de photolithographie à haute résolution comprend les sous-étapes suivantes :
- former un moule positif de l'objet à fabriquer dans un premier matériau,
- réaliser dans ou sur le moule positif un dépôt électrolytique d'un second matériau, métallique, et qui est le matériau résistant destiné à constituer le moule négatif,
- éliminer le premier matériau pour récupérer le moule négatif constitué du second matériau,
et dans lequel l'étape de dépôt par voie sèche est réalisée dans ou sur le moule négatif en second matériau.

Avantageusement, dans un dixième mode de réalisation du procédé de l'invention, selon le mode de réalisation précédent, le premier matériau est une résine photosensible.

Avantageusement, dans un onzième mode de réalisation du procédé de l'invention, selon l'un des deux modes de réalisation précédents, le second matériau formant le moule négatif est un dépôt électrolytique.

En effet, le second matériau formant le moule négatif est de préférence du nickel et dans ce cas, le dépôt du second matériau peut être électrolytique.

Avantageusement, dans un douzième mode de réalisation du procédé de l'invention, selon le neuvième ou le onzième mode de réalisation, le second matériau formant le moule négatif est éliminé par attaque chimique. Ceci permet de récupérer l'objet final.

Avantageusement, dans un treizième mode de réalisation du procédé de l'invention, selon l'un des modes de réalisation précédents, le dépôt par voie sèche est choisi parmi :
- un dépôt par Pulvérisation Cathodique Triode (PCT),
- un dépôt chimique en phase vapeur ou CVD (abréviation de Chemical Vapor Deposition), assisté ou non par plasma,
- un dépôt par frittage à plasma d'étincelles ou SPS (abréviation de Spark Plasma Sintering),
- un dépôt physique en phase vapeur ou PVD (abréviation de Physical Vapor Deposition),
- un dépôt physique par évaporation, par exemple un dépôt physique en phase vapeur par faisceau d'électrons ou EB-PVD (abréviation de Electron Beam Physical Vapor Deposition).

Avantageusement, dans un quatorzième mode de réalisation du procédé de l'invention, selon le mode de réalisation précédent, le dépôt par voie sèche est un dépôt par Pulvérisation Cathodique Triode (PCT).

Toutefois, on peut également faire appel à d'autres types de dépôts comme un dépôt chimique en phase vapeur ou "CVD" (abréviation de Chemical Vapor Deposition) assisté ou non par plasma.

On peut également utiliser un dépôt par frittage à plasma d'étincelles, ou SPS (abréviation de « Spark Plasma Sintering ») ou encore un dépôt physique en phase vapeur ou PVD (abréviation de « Physical Vapor Deposition »).

Enfin, on peut encore utiliser des procédés par évaporation comme le procédé EB-PVD (abréviation de « Electron Beam Physical Vapor Deposition » qui signifie «dépôt physique en phase vapeur par faisceau d'électrons »).

Les principaux avantages de la pulvérisation cathodique triode par rapport à la PVD (deux électrodes de part et d'autre d'un plasma) sont :
- que la décharge peut être obtenue à une pression plus faible, de l'ordre de 10⁻¹ à 10⁻² Pa, ce qui est un avantage du point de vue de la contamination des couches déposées, par le gaz utilisé pour former le plasma ;
- que la troisième électrode (placée au niveau du substrat) permet d'accélérer la vitesse d'obtention du dépôt par voie sèche : 10 à 15 µm par heure, ce qui la rapproche de la vitesse d'électroformage obtenue en galvanoplastie (entre 10 et 100 µm par heure).

Avantageusement, dans un quinzième mode de réalisation du procédé de l'invention, selon l'un des modes de réalisation précédents, on répète au moins une fois l'étape de lithographie à haute résolution et l'étape de dépôt par voie sèche avec un autre matériau inorganique pour réaliser un objet formé d'au moins deux matériaux inorganiques différents.

Avantageusement, dans un seizième mode de réalisation du procédé de l'invention, selon l'un des modes de réalisation précédents, lequel le matériau inorganique est choisi parmi : les métaux purs, les alliages multi-composant, les superalliages, ou toute céramique obtenue par ce procédé et leurs mélanges.

Ainsi, l'invention repose sur une combinaison unique de deux techniques dont la combinaison n'avait jamais été envisagée conjointement jusqu'à présent.

La photolithographie haute résolution, par exemple par rayonnements X ou UV, a pour but de réaliser un moule positif ou négatif de précision micrométrique (donc a priori non déformable) de l'objet à fabriquer. C'est en effet la précision de la photolithographie X ou UV du masque qui détermine la précision de l'objet fabriqué dans le plan du masque de photolithographie. Quant au parallélisme entre la génératrice de direction Z et les parois générées, la photolithographie X permet d'obtenir une précision meilleure qu'un micromètre par millimètre d'épaisseur selon la direction Z alors que la photolithographie UV ne permet d'obtenir cette précision que sur une épaisseur mille fois inférieure, c'est-à-dire une épaisseur de un ou de quelques micromètres.

Le dépôt par voie sèche permet d'utiliser une très grande variété de matériaux, à savoir tout matériau inorganique et notamment les alliages dont le nombre de constituants est pratiquement illimité.

De ce fait, on obtient les principaux résultats et avantages suivants.

Tout d'abord, une grande précision d'usinage puisqu'il s'agit de la précision de la méthode de photolithographie.

Ensuite, il est possible de réaliser des objets de micromécanique de grande dimension, éventuellement par assemblage d'objets petits et/ou peu épais (c'est-à-dire de quelques couches atomiques à environ 1mm).

Enfin, le procédé de l'invention supprime le verrou technologique que constitue la limitation de choix du matériau, induite par les dépôts électrolytiques, et notamment l'impossibilité de déposer des alliages complexes.

En effet, grâce à l'invention, les matériaux utilisables sont tous les matériaux inorganiques (alliages métalliques, céramiques, etc..) dont des matériaux à propriétés exceptionnelles, tels que les alliages réfractaires, les alliages à mémoire de forme, les matériaux hétérogènes, les céramiques (oxydes, nitrures, carbures, etc...).

Un avantage supplémentaire de l'invention est qu'elle permet de réaliser des objets composés de plusieurs matériaux, sans interface d'assemblage, obtenus chacun par la technique ci-dessus.

Autrement dit, il est possible de répéter au moins une fois l'étape de lithographie à haute résolution et l'étape de dépôt par voie sèche avec un autre matériau inorganique pour réaliser un objet formé d'au moins deux matériaux inorganiques différents.

Si l'on considère le cas particulier du procédé combinant une photolithographie haute résolution (LIGA) et un formage par pulvérisation cathodique triode (PCT), on obtient les caractéristiques suivantes. Tout d'abord, grâce à cette combinaison, on enrichit de manière quasi infinie la nature des matériaux pouvant être déposés : de l'élément chimique à l'alliage le plus complexe, tout en conservant la précision obtenue actuellement avec les seuls éléments chimiques déposables par galvanoplastie.

En fonction de la voie utilisée (directe ou indirecte) pour l'étape photolithographique, les épaisseurs obtenues vont de quelques couches atomiques au millimètre.

On obtient les mêmes résultats et avantages que précédemment :
- précision de formage de l'ordre du micromètre dans toutes les directions avec une photolithographie X (erreur de pente inférieure à 1 µm / mm), ce qui conduit à une précision de formage jamais atteinte, dans l'état de l'art, avec un superalliage. Dans le cas d'épaisseurs faibles (dépôts inférieurs à quelques micromètres), l'utilisation de la photolithographie UV permet de garantir une précision de formage de plus ou moins 1 micromètre dans toutes les directions, ce qui conduit également à une précision de formage jamais atteinte, dans l'état de l'art, avec un superalliage ;
- les objets peuvent être de grande dimension (éventuellement par assemblage de petits objets) ou de très petite et/ou très fine dimension (quelques couches atomiques à environ 1mm) ;
- les matériaux utilisables peuvent être tous les matériaux inorganiques ;
- il est possible aussi de réaliser des objets à partir de plusieurs matériaux déposés successivement (composants multi-matériaux).

Sous un autre aspect, l'invention concerne un objet tel qu'obtenu par la mise en oeuvre du procédé ci-dessus.

Plus précisément, la présente demande vise un objet micromécanique de grande précision caractérisé en ce qu'il est de précision micrométrique sur une hauteur millimétrique, qu'il comprend au moins une partie en forme de cylindre droit de génératrice parallèle à une direction Z, et qu'il est formé d'au moins un matériau inorganique non déposable par galvanoplastie mais déposable par voie sèche.

Un tel objet peut être, par exemple, réalisé sous la forme d'une butée spirale comprenant une face annulaire sur laquelle sont formés des bossages délimités par des rainures en spirale d'une profondeur de quelques micromètres.

Un tel objet peut aussi être, par exemple, réalisé sous la forme d'un palier à lobes de dimension millimétrique.

L'invention sera décrite maintenant en référence à quatre exemples de réalisation et aux dessins annexés, ces exemples et dessins étant donnés uniquement à titre illustratif.

Sur les dessins annexés :
- la figure 1 est une vue de face d'une butée munie de rainures en spirale, pouvant être obtenue par le procédé de l'invention ;
- la figure 2 est une vue en coupe suivant la ligne II-II de la figure 1 ;
- la figure 3 représente le détail III de la figure 2 à échelle agrandie ;
- la figure 4 est une vue de face d'un palier à lobes pouvant être obtenu par le procédé de l'invention ;
- la figure 5 est une vue de face d'un palier à lobes analogue à celui de la figure 4 inséré dans un tube de réception ;
- la figure 6 est une vue de dessus d'un moule en résine formé sur un substrat ;
- la figure 7 est une vue analogue à la figure 6 après formation d'un objet en nickel dans le moule ;
- les figures 8A et 8B sont respectivement une vue de face et une vue de profil de l'objet en nickel de la figure 7, une fois séparé du moule ;
- les figures 9A et 9B sont respectivement une vue de face et une vue en coupe axiale d'un assemblage formé par l'empilement de quatre objets en nickel sur un axe ;
- les figures 10A et 10B sont des vues analogues aux figures 9A et 9B après dépôt PCT d'un superalliage ;
- les figures 11A et 11B sont des vues analogues aux figures 10A et 10B après rectification de la surface externe du dépôt de superalliage ;
- les figures 12A et 12B sont des vues analogues aux figures 11A et 11B après ajustement de l'assemblage dans un tube de réception ; et
- les figures 13A et 13B sont des vues analogues aux figures 12A et 12B après dissolution du nickel, ce qui permet d'obtenir le palier à lobes ajusté dans le tube de réception.

### Exemple I : Fabrication d'une butée à gaz à rainures en spirales en superalliage (procédé direct)

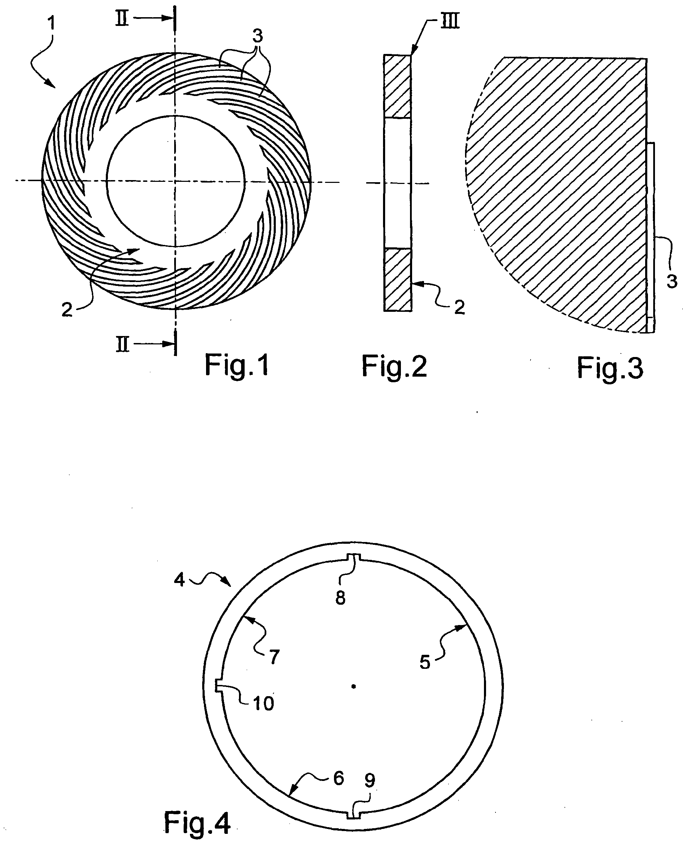

On se propose de fabriquer une butée à gaz à rainures en spirales 1 pour une microturbine, comme représentée sur les figures 1 à 3. La butée 1 est un objet de très petite dimension devant être réalisé en superalliage base nickel car il devra subir de très fortes températures en milieu oxydant. Il s'agit d'un objet annulaire dont le diamètre extérieur est de l'ordre de la dizaine de millimètres. L'une des faces annulaires 2 est microstructurée avec des bossages délimités par des rainures en spirale 3 d'une profondeur constante définie entre quelques micromètres et quelques dizaines de micromètres (voir le détail de la figure 3). Un tel usinage est impossible par les techniques conventionnelles (électroérosion, fraisage, etc...).

De même, la photolithographie UV associée à la galvanoplastie ne peut pas réaliser des objets en superalliage à base nickel.

Conformément à l'invention, afin d'assurer une erreur de pente inférieure à 1 µm/mm pour les parois générées dans la direction Z, on a choisi de construire ce type de butée à rainures en spirales en réalisant le négatif des bossages, soit par photolithographie X, pour une hauteur constante de l'ordre de quelques micromètres, soit par photolithographie X ou UV, pour une hauteur inférieure, l'étape de photolithographie étant_suivie d'un dépôt PCT de superalliage.

On utilise ici un procédé de photolithographie sur un substrat approprié. Pour ce faire, le substrat retenu est un superalliage appelé "IN 100" de composition suivante :

| Eléments | Ni | Co | Cr | Al | Ti | Fe | Mo | V | Nb | C | Zr | B |
|---|---|---|---|---|---|---|---|---|---|---|---|---|
| %massique | 59,2 | 13,2 | 10,3 | 5,2 | 4,2 | 3,3 | 3,0 | 0,9 | 0,6 | 0,17 | 0,05 | 0,01 |

Ce substrat a été revêtu de résine photosensible (par exemple SU-8) (résine négative) qui peut résister à des températures de l'ordre de 300°C sous vide. Un masque photolithographique est placé sur la résine et la photolithographie est effectuée pour réaliser un moule négatif en résine photosensible. Ce point a été vérifié par analyse thermogravimétrique (ATG). Une cible en superalliage IN 738LC, dont la fonction est d'apporter le matériau constitutif de l'objet à fabriquer, a été usinée et mise en place. La composition de cet alliage est la suivante :

| Eléments | Ni | Cr | Co | Mo | W | Ta | Nb | Al | Ti | C | B | Zr |
|---|---|---|---|---|---|---|---|---|---|---|---|---|
| %massique | 61 | 16,0 | 8,5 | 1,7 | 2,6 | 1,7 | 0,9 | 3,4 | 4,5 | 0,1 | 0,02 | 0,1 |

Le substrat a été placé sur un porte-substrat refroidi de façon à ce que sa température soit toujours inférieure à 300 °C. Les paramètres de pulvérisation choisis sont les suivants : puissance dissipée inférieure à 7,6 W/cm² (soit un courant de polarisation de la cible de 0,8 A) pour une distance cible-substrat de 40 mm. Dans ces conditions, on a obtenu un dépôt dont la composition chimique est identique à celle de la cible. Il est à noter que les dépôts par voie sèche peuvent être effectués parallèlement à la direction Z de photolithographie (comme pour cet exemple et l'exemple 4 qui suit) ou perpendiculairement à cette direction Z (comme pour les exemples 2 et 3 qui suivent) ou encore selon un autre angle.

A ce stade, le dépôt ne présente pas encore la microstructure caractéristique d'un superalliage: Aussi, les opérations de destruction du masque en résine SU-8 utilisé dans la lithographie ont été confondues avec le traitement d'homogénéisation du superalliage. Pour ce faire, l'ensemble substrat en IN 100 + bossages en spirale en IN738 LC + résine SU-8 a été porté à la température de 1120°C pendant deux heures sous argon, puis a subi un revenu à 845 °C pendant 24 heures sous air. Il va sans dire que le premier traitement a totalement détruit la résine organique et que le second traitement a éliminé toute trace carbonée de la surface.

Un examen métallographique effectué à l'issue de ces opérations montre trois résultats importants :
1°) L'interface substrat/dépôt est quasiment invisible. Tout se passe comme si les bossages avaient été usinés dans la masse ;
2°) Le dépôt présente une microstructure typique de superalliage γ/γ' avec, cependant, une distribution de la phase γ' plus fine que celle constatée dans le substrat IN100 ;
3°) Le traitement thermique n'a pas déformé le dépôt.

Enfin, l'objet ainsi créé a été soumis à un test d'oxydation à haute température, comme il est d'usage pour tout objet devant être utilisé dans les conditions environnementales (atmosphère corrosive, etc.) sévères d'une turbine à gaz. Pour ce faire, la butée spirale fabriquée par photolithographie suivie d'un dépôt PCT a été testée en oxydation isotherme à 1100°C pendant 50 heures. Aucun décollement des spirales n'a été observé. A l'issue du test, on constate la formation d'une couche d'oxydes à la surface des spirales. La microstructure sous jacente est redevenue monophasée γ, ce qui s'explique par la consommation de l'aluminium de la phase γ' pour former un oxyde protecteur Al₂O₃. Cependant, on a noté que, par rapport à l'alliage massif qui constituait le substrat, la zone de déplétion en aluminium est réduite. Cette meilleure résistance du dépôt PCT est probablement due à l'obtention d'une microstructure extrêmement fine, plus fine que celle obtenue avec un matériau massif.

Avec cette technique, il est désormais possible de créer des objets en superalliage d'une précision jamais atteinte auparavant : des cotes garanties au micromètre avec une microstructure adaptée à l'usage.

### Exemple II : Fabrication d'un palier à gaz en superalliage (procédé indirect)

On se propose de fabriquer des paliers à lobes, constitués par des arcs de cercle décentrés, de grande précision et de grande longueur. Un tel palier à gaz 4 est représenté en vue de face sur la figure 4. Il s'agit d'un objet de section annulaire délimitée intérieurement par trois arcs de cercle 5, 6 et 7 dont les centres sont décalés. Ces arcs de cercle sont séparés par des encoches respectives 8, 9 et 10 formant des rainures axiales. Le palier 4 présente un diamètre extérieur de l'ordre de 5 à 6 mm et une longueur axiale de 4 mm. Pour construire cet objet, on réalise, par photolithographie profonde par rayons X, quatre moules positifs de 1 mm d'épaisseur en polymère. Cette technique permet de garantir que le parallélisme des parois d'une microstructure par rapport à la direction Z présente une erreur de pente inférieure à 1 micromètre par millimètre. Les 4 positifs sont ensuite empilés les uns sur les autres, l'alignement étant assuré par des détrompeurs. Ensuite, à l'aide d'une anode centrée sur le tube, un dépôt électrolytique de nickel est effectué à l'intérieur du tube « lobé » qui a été auparavant argenté chimiquement pour obtenir une surface conductrice d'électricité (comme il est bien connu de l'homme de l'art), jusqu'à obtention d'une épaisseur suffisante pour obtenir un dépôt manipulable (0,3 mm dans le cas présent). On utilise, ici, un substrat conducteur de l'électricité, par exemple un alliage d'aluminium tel que AU4G, connu sous la dénomination commerciale Duralumin ou Dural.

La résine préalablement déposée sur le substrat est ensuite détruite, ce qui permet d'obtenir un moule négatif en nickel électrolytique. Ce moule négatif est ensuite placé au centre d'une cible circulaire en IN738 LC (superalliage) et la phase de dépôt proprement dite peut commencer. L'épaisseur du dépôt est de 0,5 mm. A l'issue de cette opération et avant démontage, l'extérieur du dépôt est rectifié de façon à pouvoir entrer avec un jeu faible (norme ISO H7G6) dans un autre tube, lisse cette fois ci. Après cette opération de rectification, le nickel est dissous dans une solution d'acide nitrique (50 % en volume) additionnée d'un gramme de chlorure de potassium par litre. Le superalliage ne peut être attaqué chimiquement dans ces conditions.

A l'issue de ces opérations, le palier à lobes en superalliage est homogénéisé à 1120 °C pendant deux heures sous argon avec getter pour l'oxygène, traitement suivi d'un revenu à 845 °C pendant 24 heures, toujours sous argon, avec getter pour l'oxygène. Cette dernière précaution est prise pour éviter toute oxydation des lobes. Ce traitement en deux parties est classiquement appliqué aux superalliages au cours de leur élaboration pour, dans un premier temps, précipiter une phase γ' finement dispersée et, dans un second temps, stabiliser cette même phase γ'. A l'issue de ce traitement, on obtient une microstructure biphasée γ/γ'.

Une fois introduit dans un tube ou manchon de réception, on obtient un palier à lobes de très grande précision en superalliage IN738 LC à microstructure fine. Il était jusqu'ici strictement impossible de pouvoir usiner un tel superalliage (IN738 LC) sur une telle longueur (4 mm) avec une telle précision (inférieure au micromètre), quel que soit le moyen d'usinage employé.

### Exemple III : Fabrication d'un palier à gaz en superalliage (procédé indirect)

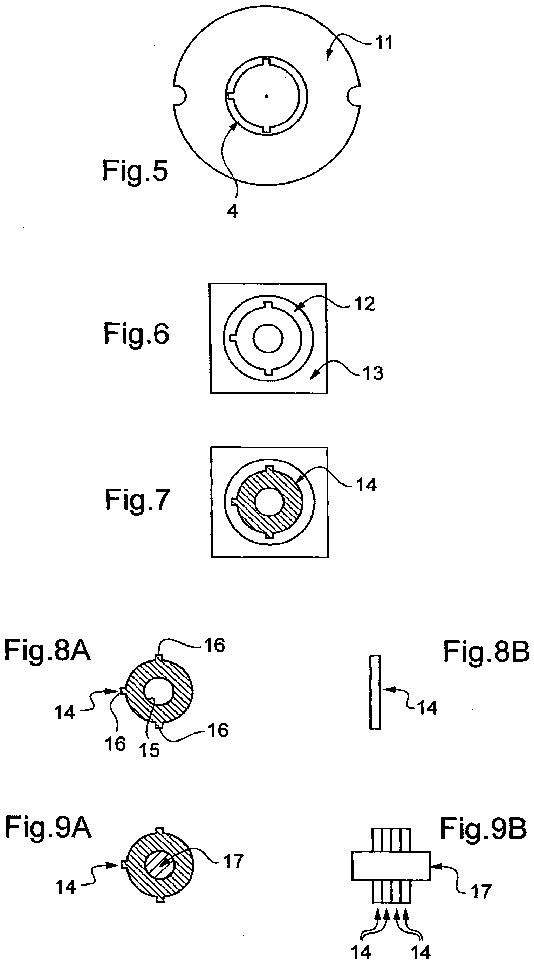

Comme dans l'exemple II, on se propose de fabriquer un palier à lobes de grande dimension et de grande longueur en superalliage. Le palier à gaz 4 de la figure 5 est analogue à celui de la figure 4, sauf qu'il est ici inséré dans un tube de réception 11 formant manchon.

Par rapport à l'exemple II, seul le procédé d'obtention de la forme complémentaire en nickel change. Dans cet exemple, les formes complémentaires des paliers à lobes sont réalisées par photolithographie X profonde dans une couche 12 de résine PMMA (polyméthacrylate de méthyle) sur un substrat 13 conducteur de l'électricité (figure 6). Ce substrat peut être, comme dans l'exemple II, un alliage d'aluminium tel que l'alliage AU4G, connu sous la dénomination commerciale Duralumin ou Dural.

Par la suite, une empreinte des lobes est réalisée par électro-croissance de nickel dans le moule polymère pour former un objet en nickel 14 de forme annulaire (figure 7).

Un polissage mécano-chimique permet d'amener chacun des objets de nickel 14 à la bonne épaisseur (1mm par exemple). Un ébavurage électrochimique est effectué pour éliminer les copeaux résiduels produits lors du polissage. Puis le moule en PMMA est détruit par dissolution dans un solvant organique et le décollement des objets de nickel 14 est réalisé par attaque chimique du substrat. Dans le cas de l'alliage AU4G, cette attaque est faite dans une solution basique de soude (NaOH) à 10 g/L, cette solution étant inoffensive pour le nickel électroformé.

On obtient ainsi des objets de nickel 14 analogues à ceux représentés sur les figures 8A et 8B. Chacun des objets 14 est muni d'un trou de centrage 15 avec détrompeur et comporte extérieurement des ergots en saillie 16 dont le nombre correspond à celui des lobes.

Les objets 14 (ici au nombre de quatre) sont empilés les uns sur les autres sur un axe de centrage 17, comme montré sur les figures 9A et 9B. L'alignement précis des objets en nickel 14 est assuré par les détrompeurs.

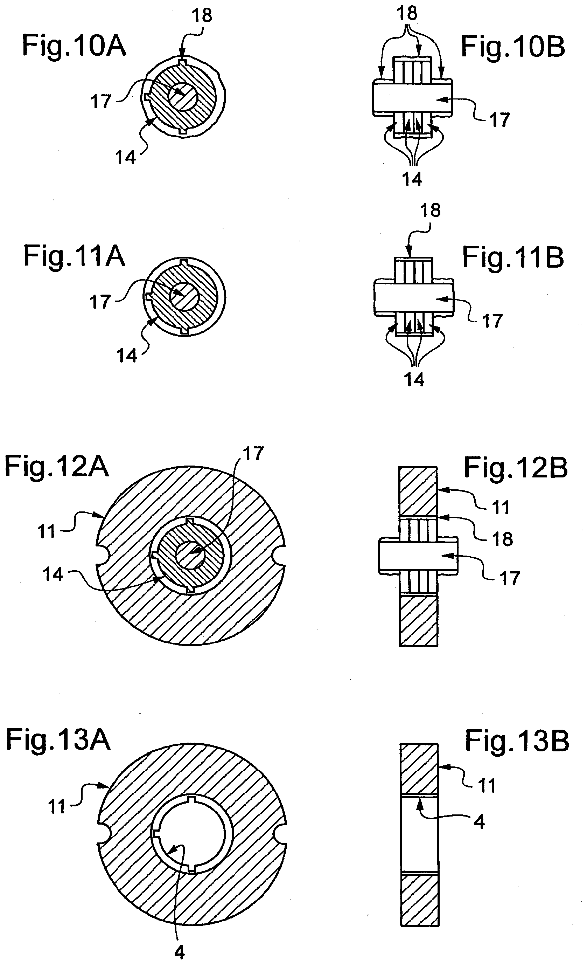

L'ensemble ainsi formé est ensuite placé au centre d'une cible circulaire en alliage IN738 LC et la phase de dépôt PCT proprement dite peut commencer. L'épaisseur du dépôt 18 est de 0,5 mm (figures 10A et 10B).

Comme dans l'exemple II, à l'issue de cette opération et avant démontage, l'extérieur du dépôt 18 est rectifié de façon à procurer une surface cylindrique lisse (figures 11A et 11B).

Ceci permet à l'ensemble ainsi obtenu de s'ajuster en côte serrée (jeu normalisé H7G6) dans un autre tube lisse qui constitue le tube de réception 11 de la figure 5.

Après cette opération de rectification, le nickel est dissous dans une solution d'acide nitrique (50% en volume) additionnée d'un gramme de chlorure de potassium par litre. Le superalliage ne peut être attaqué chimiquement dans ces conditions.

A l'issue de ces opérations, le palier à lobes en superalliage est homogénéisé à 1120°C pendant deux heures sous argon avec getter pour l'oxygène, traitement suivi d'un revenu à 845 °C pendant 24 heures, toujours sous argon, avec getter pour l'oxygène. Cette dernière précaution est prise pour éviter toute oxydation des lobes. Ce traitement en deux parties est classiquement appliqué aux superalliages au cours de leur élaboration pour, dans un premier temps, précipiter une phase γ' finement dispersée et, dans un second temps, stabiliser cette même phase γ'. A l'issue de ce traitement, on obtient bien une structure biphasée γ/γ'.

Une fois introduit dans le tube de réception 11, on obtient un palier à lobes de très grande précision en superalliage IN738 LC à microstructure fine. Il était jusqu'ici strictement impossible de pouvoir usiner un tel superalliage (IN738 LC) sur une telle longueur (4mm) avec une telle précision (inférieure au micromètre) quel que soit le moyen d'usinage employé.

### Exemple IV - Fabrication d'un objet de grande précision à partir de plusieurs matériaux

On se propose de fabriquer un objet de démonstration de taille millimétrique utilisant plusieurs matériaux. Le premier alliage choisi est un alliage à mémoire de forme, à savoir le nitinol de composition stoechiométrique NiTi. Le second matériau est une céramique de type alumine et le troisième un autre intermétallique, γ-TiAl. Pour ce faire, le substrat sur lequel l'échantillon doit être construit est une plaque en céramique. Ici aussi, la précision des différentes parties doit être de l'ordre du micromètre.

Pour ce faire, on utilise la séquence suivante :
- dépôt sur une plaque d'alumine d'une résine photosensible SU-8. Révélation de la forme désirée après illumination par une source d'UV ou de rayons X ;
- dépôt par PCT du NiTi sur un substrat refroidi (moins de 300°C) ;
- positionnement d'un masque en nickel électrolytique obtenu par photolithographie X ;
- dépôt de la céramique par PVD radiofréquence (PVD-RF) ;
- dépôt sur l'ensemble NiTi + alumine d'une dernière couche de SU-8 (résine) ;
- révélation de la dernière forme après illumination par une source d'UV ou de rayons X ;
- dépôt par PCT du troisième alliage, le γ-TiAl ;
- élimination de tous les restes de SU-8 et dissolution du nickel électrolytique dans un bain de HNO₃ au demi, additionné de 1g/L de KCl.

A l'issue de ces opérations, on obtient un objet bimétallique avec un axe en céramique. Au vu de la nature des matériaux déposés, il est impossible d'obtenir ceci par fabrication directe (dépôt électrolytique, etc..). Cet exemple a été choisi pour démontrer la versatilité du procédé de l'invention.

Ainsi, l'invention trouve une application préférentielle dans la fabrication d'objets micromécaniques de grande précision en particulier dans le domaine de l'aéronautique, de l'horlogerie, etc...

## Revendications

1. Procédé de fabrication d'un objet micromécanique de dimension millimétrique ou supérieure, de grande précision, formé d'au moins un matériau inorganique, **caractérisé en ce qu'**il comprend les étapes suivantes :
- utiliser un procédé de photolithographie à haute résolution mettant en oeuvre, suivant une direction choisie Z, un rayonnement de longueur d'onde adaptée, pour former, sur ou dans un substrat de matériau choisi, un moule négatif de précision micrométrique sur une hauteur millimétrique comportant au moins une partie en forme de cylindre droit de génératrice parallèle à la direction choisie Z, ledit moule négatif étant non déformable à l'échelle micrométrique au cours des étapes du procédé, dans un matériau résistant aux conditions physico-chimiques et de température d'une étape de formage de l'objet par dépôt par voie sèche et pouvant soit être éliminé sans altération de l'objet qui aura été fabriqué, soit être séparé dudit objet, ledit matériau résistant étant soit une résine photosensible, auquel cas le substrat est refroidi et fait partie intégrante dudit objet, soit un matériau déposé par galvanoplastie, auquel cas une étape préalable de formage d'un moule positif en résine photosensible de l'objet est réalisée;
- choisir, indépendamment du potentiel normal d'oxydoréduction de ses éléments constitutifs, au moins un matériau inorganique parmi l'ensemble des matériaux non déposables par galvanoplastie mais pouvant être déposés par voie sèche; et
- réaliser, au moyen du moule négatif non déformable, par dépôt par voie sèche dudit au moins un matériau inorganique, un formage d'objet micromécanique de dimension millimétrique ou supérieure.

2. Procédé selon la revendication 1, dans lequel le moule négatif est formé directement dans le matériau résistant.

3. Procédé selon la revendication 1, dans lequel le matériau résistant est une résine photosensible déposée sur ledit substrat.

4. Procédé selon la revendication 1, dans lequel le matériau résistant est un métal déposé sur ledit substrat.

5. Procédé selon l'une des revendications 1 à 4, dans lequel le procédé de photolithographie à haute résolution est un procédé de photolithographie mettant en oeuvre un rayonnement X.

6. Procédé selon l'une des revendications 1 à 4, dans lequel le procédé de photolithographie à haute résolution est un procédé de photolithographie mettant en oeuvre un rayonnement UV.

7. Procédé selon l'une des revendications 1 à 6, comprenant les étapes ultérieures suivantes :
- éliminer le moule négatif ou le séparer de l'objet à fabriquer; et
- récupérer l'objet ainsi fabriqué.

8. Procédé selon l'une des revendications précédentes, dans lequel l'étape du procédé relatif à la photolithographie à haute résolution comprend les sous-étapes suivantes :
- former un moule positif de l'objet à fabriquer dans un premier matériau,
- réaliser dans ou sur le moule positif un dépôt électrolytique d'un second matériau, métallique, et qui est le matériau résistant destiné à constituer le moule négatif,
- éliminer le premier matériau pour récupérer le moule négatif constitué du second matériau,
et dans lequel l'étape de dépôt par voie sèche est réalisée dans ou sur le moule négatif en second matériau.

9. Procédé selon la revendication précédente, dans lequel le premier matériau est une résine photosensible.

10. Procédé selon l'une des revendications 8 et 9, dans lequel le second matériau formant le moule négatif est un dépôt électrolytique.

11. Procédé selon les revendications 8 à 10, dans lequel le second matériau formant le moule négatif est éliminé par attaque chimique.

12. Procédé selon l'une des revendications précédentes, dans lequel le dépôt par voie sèche est choisi parmi :
- un dépôt par Pulvérisation Cathodique Triode (PCT),
- un dépôt chimique en phase vapeur ou CVD (abréviation de Chemical Vapor Deposition), assisté ou non par plasma,
- un dépôt par frittage à plasma d'étincelles ou SPS (abréviation de Spark Plasma Sintering),
- un dépôt physique en phase vapeur ou PVD (abréviation de Physical Vapor Deposition),
- un dépôt physique par évaporation, par exemple un dépôt physique en phase vapeur par faisceau d'électrons ou EB-PVD (abréviation de Electron Beam Physical Vapor Deposition).

13. Procédé selon la revendication précédente, dans lequel, le dépôt par voie sèche est un dépôt par Pulvérisation Cathodique Triode (PCT),

14. Procédé selon l'une des revendications précédentes, dans lequel on répète au moins une fois l'étape de lithographie à haute résolution et l'étape de dépôt par voie sèche avec un autre matériau inorganique pour réaliser un objet formé d'au moins deux matériaux inorganiques différents.

15. Procédé selon l'une des revendications précédentes, dans lequel le matériau inorganique est choisi parmi : les métaux purs, les alliages multi-composant, les superalliages, ou toute céramique obtenue par ce procédé et leurs mélanges.

16. Objet micromécanique de grande précision tel qu'obtenu par la mise en oeuvre d'un procédé selon l'une des revendications précédentes, **caractérisé en ce qu'**il est de précision micrométrique sur une hauteur millimétrique, qu'il comprend au moins une partie en forme de cylindre droit de génératrice parallèle à une direction Z, et qu'il est formé d'au moins un matériau inorganique non déposable par galvanoplastie mais déposable par voie sèche.

17. Obj et selon la revendication précédente, réalisé sous la forme d'une butée spirale (1) comprenant une face annulaire (2) sur laquelle sont formée des bossages délimitant des rainures en spirale (3) d'une profondeur de quelques micromètres.

18. Objet selon la revendication 16, réalisé sous la forme d'un palier à lobes (4) de dimension millimétrique.

## Patentansprüche

1. Verfahren zur Herstellung eines mikromechanischen Objekts mit Millimeterabmessung oder größer, das aus mindestens einem anorganischen Material ausgebildet wird, von großer Präzision, **dadurch gekennzeichnet, dass** das Verfahren die folgenden Schritte umfasst:
- ein hochauflösendes Photolithographieverfahren zu verwenden, das in einer ausgewählten Richtung Z eine Strahlung mit angepasster Wellenlänge einsetzt, um auf oder in einem Substrat eines ausgewählten Materials eine Negativform mit Mikrometerpräzision über eine Millimeterhöhe, die zumindest einen Teil in Form eines geraden Zylinders mit einer zur ausgewählten Richtung Z parallelen Mantellinie aufweist, wobei die Negativform im Mikrometermaßstab während der Schritte des Verfahrens nicht verformbar ist, in einem Material auszubilden, das den physikalisch-chemischen und Temperaturbedingungen eines Schritts zur Formgebung des Objekts durch Trockenabscheidung widersteht und entweder ohne Veränderung des Objekts, das hergestellt sein wird, eliminiert oder vom Objekt getrennt werden kann, wobei das widerstandsfähige Material entweder ein lichtempfindliches Harz ist, in welchem Fall das Substrat abgekühlt wird und einen integralen Teil des Objekts bildet, oder ein galvanoplastisch abgeschiedenes Material ist, in welchem Fall ein Vorschritt zur Formgebung einer Positivform aus lichtempfindlichem Harz des Objekts ausgeführt wird;
- unabhängig vom normalen Redoxpotential seiner Bestandteile mindestens ein anorganisches Material aus der Gesamtheit an Materialien auszuwählen, die nicht galvanoplastisch abgeschieden werden können, aber trockenabgeschieden werden können; und
- mittels der nicht verformbaren Negativform durch Trockenabscheidung des mindestens einen anorganischen Materials eine Formgebung des mikromechanischen Objekts mit Millimeterabmessung oder größer durchzuführen.

2. Verfahren nach Anspruch 1, wobei die Negativform direkt in dem widerstandsfähigen Material gebildet wird.

3. Verfahren nach Anspruch 1, wobei das widerstandsfähige Material ein auf dem Substrat abgeschiedenes lichtempfindliches Harz ist.

4. Verfahren nach Anspruch 1, wobei das widerstandsfähige Material ein auf dem Substrat abgeschiedenes Metall ist.

5. Verfahren nach einem der Ansprüche 1 bis 4, wobei das hochauflösende Photolithographieverfahren ein Photolithographieverfahren ist, das Röntgenstrahlung einsetzt.

6. Verfahren nach einem der Ansprüche 1 bis 4, wobei das hochauflösende Photolithographieverfahren ein Photolithographieverfahren ist, das UV-Strahlung einsetzt.

7. Verfahren nach einem der Ansprüche 1 bis 6, die folgenden weiteren Schritte umfassend:
- die Negativform zu eliminieren oder sie vom herzustellenden Objekt zu trennen; und
- das so hergestellte Objekt zu erlangen.

8. Verfahren nach einem der vorhergehenden Ansprüche, wobei der Schritt des Verfahrens in Bezug auf die hochauflösende Photolithographie die folgenden Teilschritte umfasst:
- eine Positivform des herzustellenden Objekts in einem ersten Material auszubilden,
- in oder auf der Positivform eine elektrolytische Abscheidung eines zweiten Materials herzustellen, das metallisch ist und das das widerstandsfähige Material ist, das dazu bestimmt ist, die Negativform zu bilden,
- das erste Material zu eliminieren, um die aus dem zweiten Material gebildete Negativform zu erlangen.
und wobei der Trockenabscheidungsschritt in oder auf der Negativform aus dem zweiten Material durchgeführt wird.

9. Verfahren nach dem vorhergehenden Anspruch, wobei das erste Material ein lichtempfindliches Harz ist.

10. Verfahren nach einem der Ansprüche 8 und 9, wobei das die Negativform bildende zweite Material eine elektrolytische Abscheidung ist.

11. Verfahren nach den Ansprüche 8 bis 10, wobei das die Negativform bildende zweite Material durch chemisches Ätzen eliminiert wird.

12. Verfahren nach einem der vorhergehenden Ansprüche, wobei der Trockenabscheidungsschritt ausgewählt ist aus:
- einer Abscheidung durch Triodensputtern (PCT - *Pulvérisation Cathodique Triode*).
- einer, gegebenenfalls plasmaunterstützten, chemischen Dampfphasenabscheidung oder CVD (Abkürzung für *Chemical Vapor Deposition*),
- einer Abscheidung durch Funkenplasmasinterung oder SPS (Abkürzung für *Spark Plasma Sintering*),
- einer physikalischen Dampfphasenabscheidung oder PVD (Abkürzung für *Physical Vapor Deposition*).
- einer physikalischen Abscheidung durch Verdampfung, zum Beispiel einer physikalischen Elektronenstrahl-Dampfphasenabscheidung oder EB-PVD (Abkürzung für *Electron Beam Physical Vapor Deposition).*

13. Verfahren nach dem vorhergehenden Anspruch, wobei die Trockenabscheidung eine Abscheidung durch Triodensputtern (PCT) ist.

14. Verfahren nach einem der vorhergehenden Ansprüche, wobei der hochauflösende Lithographieschritt und der Trockenabscheidungsschritt mindestens einmal mit einem anderen anorganischen Material wiederholt werden, um ein Objekt herzustellen, das aus mindestens zwei unterschiedlichen anorganischen Materialien ausgebildet ist.

15. Verfahren nach einem der vorhergehenden Ansprüche, wobei das anorganische Material ausgewählt ist aus: reinen Metallen, einer Legierung aus mehreren Komponenten, Superlegierungen oder irgendeiner durch dieses Verfahren erhaltenen Keramik und deren Gemischen.

16. Hochpräzises mikromechanisches Objekt, wie es durch den Einsatz eines Verfahrens nach einem der vorhergehenden Ansprüche erhalten wird, **dadurch gekennzeichnet, dass** es von einer Mikrometerpräzision über eine Millimeterhöhe ist, dass es zumindest einen Teil in Form eines geraden Zylinders mit einer zur ausgewählten Richtung Z parallelen Mantellinie aufweist, und dass es aus mindestens einem anorganischen Material ausgebildet ist, das nicht galvanoplastisch abgeschieden werden kann, aber trockenabgeschieden werden kann.

17. Objekt nach dem vorhergehenden Anspruch, das in Form eines Spirallagers (1) hergestellt ist, das eine ringartige Fläche (2) aufweist, auf der Erhebungen gebildet sind, die spiralförmige Rillen (3) mit einer Tiefe von einigen Mikrometern begrenzen.

18. Objekt nach Anspruch 16, das in Form eines Nockenlagers (4) mit Millimeterabmessung hergestellt ist.

## Claims

1. Process for fabricating a micromechanical object of millimetric size or larger, of high precision, formed of at least one inorganic material, **characterized in that** it comprises the following steps:
- using a high-resolution photolithography process employing, in a chosen direction Z, radiation of a wavelength adapted to the desired degree of precision, to form, on or in a chosen material substrate, a negative mold, having micrometric precision on a millimetric height comprising at least a part in the form of a straight cylinder whose generating line is parallel to the chosen direction Z, said negative mold being not deformable on the micrometric scale during the steps of the process, in a material that is resistant to the physicochemical and temperature conditions of a step of forming the object by dry deposition and that can either be removed without altering the fabricated object or separated from said object, said resistant material being a photosensitive resin, in which case the substrate is cooled and is an integral part of the final object, or a material deposited by electroplating in which case a prior step of forming a positive mold made of photosensitive resin of the object is carried out;
- choosing, independently of the normal redox potential of its constituent elements, at least one inorganic material from the group of materials that cannot be deposited by electroplating but can be deposited by dry deposition; and
- carrying out, by means of the non-deformable negative mold, by dry deposition of said at least one inorganic material, the forming of the micromechanical object that is of millimetric size or larger.

2. Process according to claim 1, wherein the negative mold is formed directly in the resistant material.

3. Process according to claim 1, wherein the resistant material is a photosensitive resin deposited on said substrate.

4. Process according to claim 1, wherein the resistant material is a metal deposited on said substrate.

5. Process according to any one of claims 1 to 4, wherein the high-resolution photolithography process is a photolithography process that employs X-radiation.

6. Process according to any one of claims 1 to 4, wherein the high-resolution photolithography process is a photolithography process that employs UV radiation.

7. Process according to any one of claims 1 to 6, comprising the following subsequent steps:
- removing the negative mold or separating it from the object to be fabricated; and
- recovering the object so fabricated.

8. Process according to any one of the preceding claims, wherein the step of the process relating to the high-resolution photolithography comprises the following sub-steps:
- forming a positive mold of the object to be fabricated in a first material,
- producing in or on the positive mold an electrolytic deposit of a second metallic material, which is the resistant material that is to constitute the negative mold,
- removing the first material in order to recover the negative mold constituted by the second material,
and wherein the step of dry deposition is carried out in or on the negative mold of the second material.

9. Process according to the preceding claim, wherein the first material is a photosensitive resin.

10. Process according to either claim 8 or claim 9, wherein the second material forming the negative mold is an electrolytic deposit.

11. Process according to claims 8 to 10, wherein the second material forming the negative mold is removed by chemical dissolution.

12. Process according to any one of the preceding claims, wherein the dry deposition is chosen from:
- deposition by triode sputtering (TS),
- chemical vapor deposition (CVD) or plasma-enhanced CVD,
- deposition by spark plasma sintering (SPS),
- physical vapor deposition (PVD),
- physical deposition by evaporation, for example electron beam physical vapor deposition (EB-PVD).

13. Process according to the preceding claim, wherein the dry deposition is deposition by triode sputtering (TS).

14. Process according to any one of the preceding claims, wherein the step of high-resolution lithography and the step of dry deposition are repeated at least once with a different inorganic material in order to produce an object formed of at least two different inorganic materials.

15. Process according to any one of the preceding claims, wherein the inorganic material is chosen from: pure metals, multi-component alloys, superalloys, or any ceramic obtained by that process, and mixtures thereof.

16. Micromechanical object, of high precision, as obtained by carrying out the process according to any one of the preceding claims, **characterized in that** it has micrometric precision on a millimetric height, **in that** it comprises at least one part in the form of a straight cylinder whose generating line is parallel to a direction Z, and **in that** it is formed of at least one inorganic material that cannot be deposited by electroplating but able to be deposited by dry deposition.

17. Object according to the preceding claim, produced in the form of a spiral thrust bearing (1) comprising an annular face (2) on which there are formed bosses delimiting spiral grooves (3) having a depth of several micrometers.

18. Object according to claim 16, produced in the form of a lobe bearing (4) of millimetric size.
